# EUROPEAN PATENT APPLICATION

(11) **EP 1 187 211 A2**
(43) Date of publication of application: **13.03.2002**
(21) Application number: 01307662.5
(22) Date of filing: 10.09.2001
(51) Int. Cl.: H01L 25/065, H01L 23/48

(54) **Stacked Semiconductor Device**

(30) Priority: 12.09.2000 JP 2000277189
(71) Applicant: Nokia Corporation, 02150 Espoo (FI)
(72) Inventor: Iwamoto, Takashi, Urayasu-shi Chiba-ken (JP); Yoshimura, Makoto, Tagata-gun Shizuoka-ken (JP)
(74) Representative: Slingsby, Philip Roy

(57) **Abstract**

A semiconductor device having a multilayer structure, wherein a first wafer unit used as a wafer base, other wafer units, and a circuit board are bonded in series through bumps formed on wafer unit surfaces, thereby to form a stacked-wafer-unit 3D structure. The structure makes the semiconductor device thinner, smaller in size and lighter in weight, and it can be manufactured and mass-produced by employing conventional equipment.

## Description

This application claims the Paris convention priority of Japanese patent application 2000-277189 filed on September 12, 2000, the entire disclosure of which is incorporated herein by reference.

The present invention relates to a semiconductor device for use as the electronic component of a semiconductor integrated circuit or the like, such as an ultrathin chip (thickness: 30 - 200 µm) based on wafers, and an electron device including the semiconductor device. More particularly, it relates to a 3D (three-dimensional) semiconductor device structure and a mass-producing method therefor.

Regarding a semiconductor device and a mass-producing method therefor, techniques for higher-density packaging will be increasingly required in the future. Technical innovation in the field has been eagerly desired, and various researches and developments have heretofore been made. By way of example, a 3D semiconductor device structure having through-holes in thin chips has been proposed as one concept.

Any of known 3D semiconductor device structures, however, has been fabricated by a manufacturing method based on chip-to-chipcorrespondence. Therefore, asemiconductordevice obtained has not been sufficiently satisfactory in a structural aspect, and it has not been very suitable for mass production in a manufactural aspect.

The present invent ion has been made in view of the problems of the prior art as stated above, and has for its object to provide a semiconductor device structure which contributes to make a semiconductor device thinner, smaller insize, lighter in weight, etc . in the structural aspect of the semiconductor device, which is permitted to be easily performed with conventional equipment in the market in the manufactural aspect of the semiconductor device, and which can be satisfactorily fabricated on mass-production basis in the cost aspect of the semiconductor device, and also an electron device which includes the semiconductor device structure.

In order to accomplish the above object, a semiconductor device and an electron device according to the present invention are constructed as stated below. Incidentally, reference numerals and signs affixed agree with those indicated in the drawings.
(1) A semiconductor device comprising a plurality of wafer units (10, 20, 30) which are stacked, wherein that first one (10) of the wafer units which is employed as a wafer base, and the other wafer units (20, 30) are bonded in series through bumps (21, 31, 32) which are formed on surfaces (20A, 20B, 30A, 30B) of the wafer units, thereby to form a multilayer-wafer-unit 3D structure.
(2) In the semiconductor device, each of, at least, the other wafer units (20, 30) include an integrated circuit (IC parts) . Incidentally, the first wafer unit (10) may well include an integrated circuit (IC parts).
(3) In the semiconductor device, the plurality of wafer units (10, 20, 30) are bonded by manufactural means at a wafer level of wafer-to-wafer correspondence.
(4) In the semiconductor device, each of the other wafer units (20, 30) is formed by thinning from its rear surface side.
(5) In the semiconductor device, an insulating film (insulating layer) is deposited on each of the other wafer units (20, 30), and it is etched as may be needed.
(6) An electron device comprising a semiconductor device (IC device), and a circuit board (40) to which the semiconductor device is bonded, wherein the semiconductor device is as defined in any of the above items (1) - (5).

Fig. 1 is a sectional explanatory view of a semiconductor device which is formed with a stacked-wafer-unit 3D structure according to the present invention;

Figs. 2(1) and 2(2) are explanatory views showing the situation of the bonding of waferunits inamanufacturingprocess at a wafer level according to the present invention;

Fig. 3 is a sectional explanatory view showing the structure of a wafer unit according to the present invention;

Fig. 4 is an enlarged view of the essential portions of the bonded wafer units according to the present invention;

Fig. 5 is a sectional view for explaining a structure in which the wafer unit according to the present invention is thinned from its rear surface side;

Fig. 6 is an explanatory view showing a state where the third wafer unit according to the present invention is stacked and bonded;

Fig. 7 is an explanatory view showing a state where the base member of the first wafer unit according to the present invention is thinned; and

Fig. 8 is a sectional explanatory view showing a state where the semiconductor device according to the present invention is mounted on a circuit board.

Now, embodiments of a semiconductor device and an electron device according to the present invention will be described in detail with reference to the accompanying drawings.

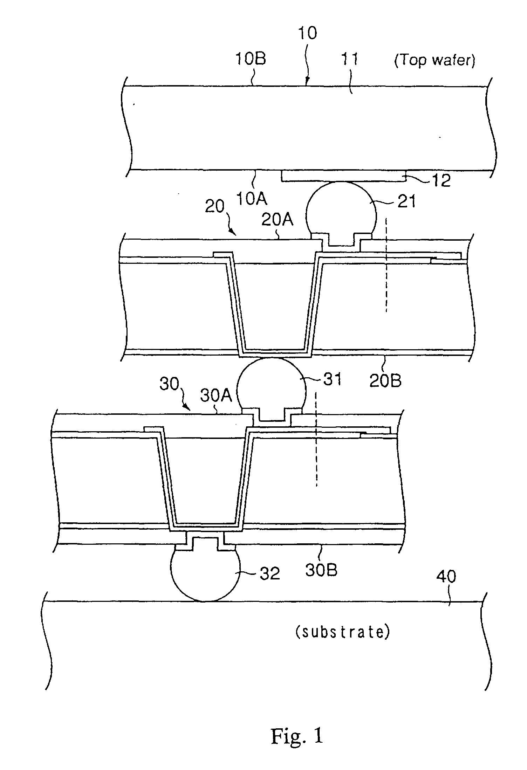

Fig. 1 is a sectional explanatory view of a semiconductor device which is formed with a multilayer-wafer-unit 3D structure in an embodiment of the present invention. The semiconductor device is fabricated having the structure in which a plurality of wafer units (10, 20, 30) are stacked in multilayer fashion. The first wafer unit 10 is constructed as a wafer base in this embodiment. The wafer base 10 chiefly includes a base member 11 made of a material such as Si or GaAs, and it also includes a pad 12 of aluminum, copper or the like on its front surface 10A. The pad 12 is bonded with the bump 21 of the wafer unit 20. The bump 21 may be any of various bumps such as a solder bump and a microbump.

In this embodiment, the second wafer unit 20 and the third wafer unit 30 are included as the other wafer units, and a circuit board 40 (such as printed circuit board or interposer) is further included. The wafer units (10, 20, 30) and the circuit board 40 are bonded in series through bumps (21, 31, 32), thereby to form the multilayer-wafer-unit 3D structure.

In Fig. 1, the first wafer unit 10 has the base member 11 made of the material such as Si or GaAs, and it includes the pad 12 on the front surface 10A as is bonded with the bump 21. Besides, the second wafer unit 20 is formed with the bump 21 on its front surface 20A, but it is not formed with any bump on its rear surface 20B. Further, the third wafer unit 30 is formed with the bump 31 on its front surface 30A, and it is also formed with the bump 32 on its rear surface 30B. As seen from Fig. 1, the first wafer unit 10, second wafer unit 20 and third wafer unit 30 mentioned from above are stacked into the multilayer sandwich-like structure, and this structure is bonded with the circuit board 40 (such as printed circuit board or interposer) through the bump 32 formed on the rear surface 30B of the third wafer unit 30.

With such a construction, the second and third wafer units 20, 30 (other wafer units) are arranged in succession to the first wafer unit 10 (top wafer) . Besides, the interposer, the PCB or the like is adopted as the circuit board 40 (printed circuit board) . According to this embodiment shown in Fig. 1, the first wafer unit 10 (top wafer) is arranged with the front surface 10A facing the circuit board 40 (such as PCB or interposer), and the second and third wafer units 20, 30 are arranged with the rear surfaces 20B, 30B facing the circuit board 40.

By the way, in the figure, the other wafer units 20, 30 are depicted including integrated circuits (IC parts), whereas the first wafer unit 10 is depicted including no integrated circuit (no IC parts) . Of course, however, also the first wafer unit 10 may well be constructed including an integrated circuit (IC parts).

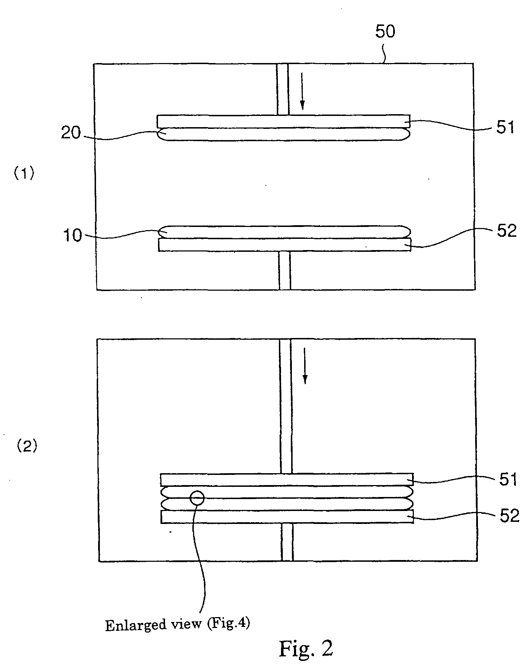

Figs. 2(1) and 2(2) are explanatory views showing the situation of the bonding of wafer units in a manufacturing process at a wafer level according to the present invention. In manufacturing the semiconductor device of the present invention, two wafer units are bonded in a wafer bonding chamber 50. In order to bond the two wafer units in register, the wafer bonding chamber 50 includes parallel chucks 51 and 52 at opposing symmetric positions. The two wafer units (here, the units 10 and 20 in Fig. 2) are set on the respective chucks 52 and 51, and these chucks bearing the wafer units are moved perpendicularly to the planes of the wafer units, whereby the wafer units are bonded to each other very easily and precisely. Incidentally, arrow (↓) in each of Figs. 2(1) and 2(2) indicates the movement of the chuck 51. Such bonding is performed by a general and standard process, and it does not resort to any special manufacturing method. It can be said a manufactural expedient at the wafer level, namely, in wafer-to-wafer correspondence.

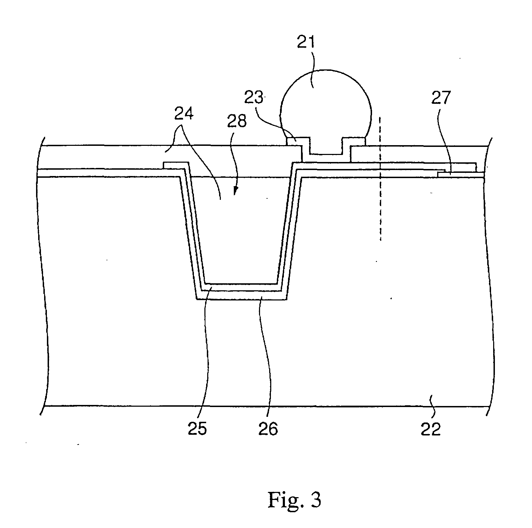

Fig. 3 is a sectional explanatory view showing an example of the structure of awaferunit according to thepresent invention. Here, the wafer unit 20 in Fig. 1 will be mentioned as the example . The principal constituents of the structure are the bump 21, a base member 22 which is made of a semiconductor material such as Si or GaAs, a UBM pad 23, an insulating layer 24 which is made of polyimide or the like, a metal layer 25 which is made of a material such as Al, Cu or Au, an insulating layer 26 which is made of SiO₂ or the like, and a metal layer 27 on the front surface side of the wafer unit as is made of the material such as Al, Cu or Au. In this example, the front surface of the wafer unit has a cavity 28, which is covered with the insulating layer 26 and the metal layer 25 and is further filled up with the polyimide or the like so as to form part of the insulating layer 24. Besides, in such a structure, the bump 21 should preferably be provided either at an upper position to which the cavity 28 is open, or at a position which is vicinal to the upper position, but the position of the provision does not depend upon the design of an IC. In the example of Fig. 3, the bump 21 is not formed at the position directly over the cavity 28, but it is formed in the vicinity of the position. Of course, however, it may well be formed at the upper position.

Incidentally, the expression "layer" here may well be reworded as "film" etc. Besides, the expression "UBM" is short for "under bump metallization".

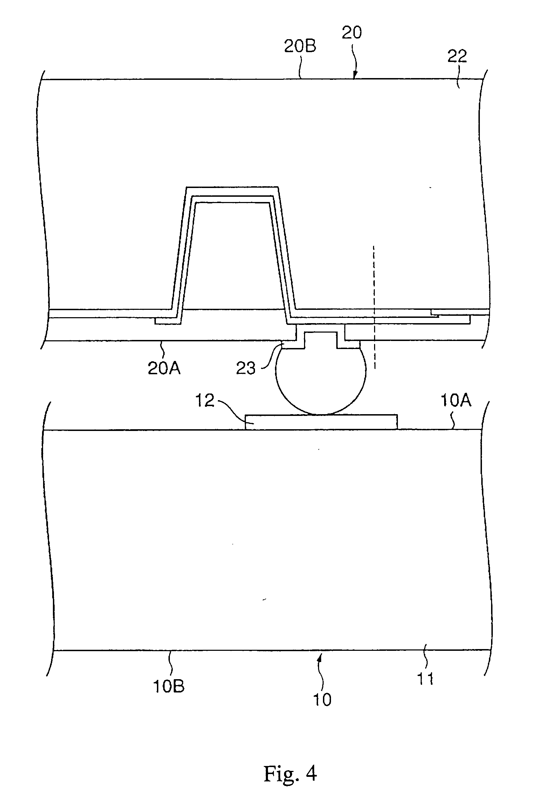

Fig. 4 is an enlarged view of the essential portions of the bonded wafer units (in Fig. 2(2)) according to the present invention. The second wafer unit 20 includes a base member 22 made of a semiconductor material such as Si or GaAs, and the base member 22 has a considerable thickness at the stage at which this wafer unit has been bonded with the first wafer unit 10. The thickness is reduced (the base member 22 is thinned) from the side of the rear surface 20B of the second wafer unit 20 at another stage.

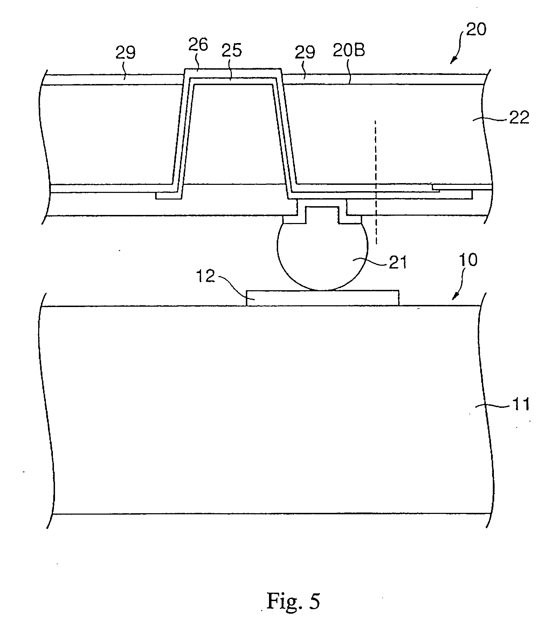

Fig. 5 is a sectional explanatory view showing a structure in which the wafer unit 20 according to the present invention has been thinned from its rear surface side. That is, the second wafer unit 20 has been thinned by thinning the base member 22 from the side of the rear surface 20B subsequently to the state of Fig. 4. After the thinning stage, a passivation film 29 (an insulating layer) is deposited on the resulting rear surface 20B of the base member 22. Further, that part of the passivation film 29 which corresponds to a metal surface (the metal layer 25) is removed by etching. The passivation film 29 is made of polyimide, SiO₂ or the like.

At the thinning stage, the thickness of the wafer unit 20 is reduced from its rear surface 20B in micrometer units at a rate of several tens percent. In the thinning operation, it is effective and favorable to employ a high-speed dry etcher which has been easily available in the market in recent years.

The bump 21 is formed by wafer bumping so as to connect with that part of the metal layer 25 which lies on the front surface (20A in Fig. 4) of the second wafer unit 20.

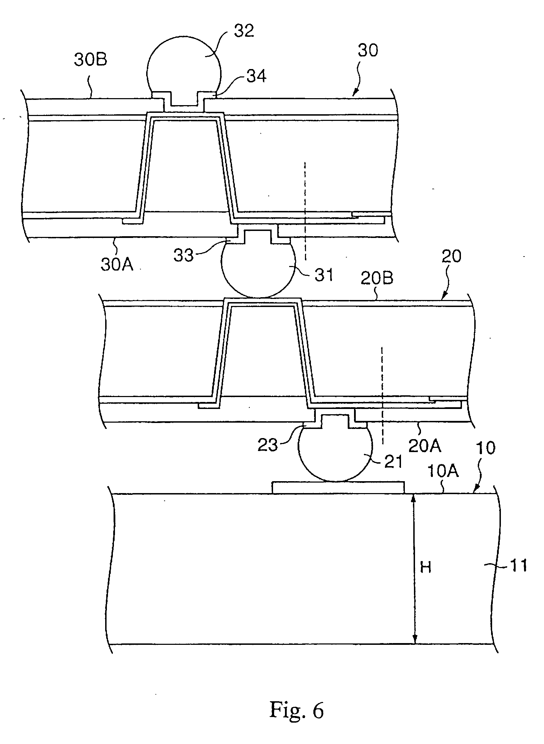

Fig. 6 is a view showing a state where the third wafer unit 30 according to the present invention has been stacked and bonded. The third wafer unit 30 is connected and bonded onto the side of the rear surface 20B of the second wafer unit 20 by the bump 31 located on the side of the front surface 30A.

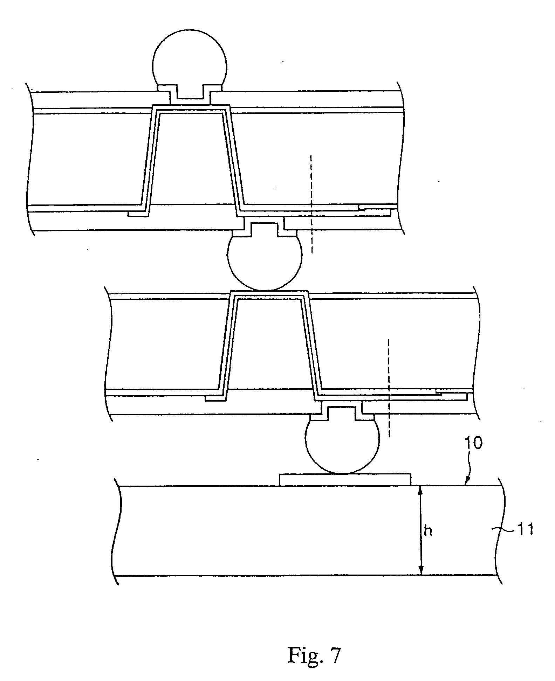

Fig. 7 is a view showing a state where the first wafer unit 10 has been thinned. The thickness of the base member 11 of the wafer unit 10 as indicated by letter H in Fig. 6 is reduced to a thickness h in Fig. 7.

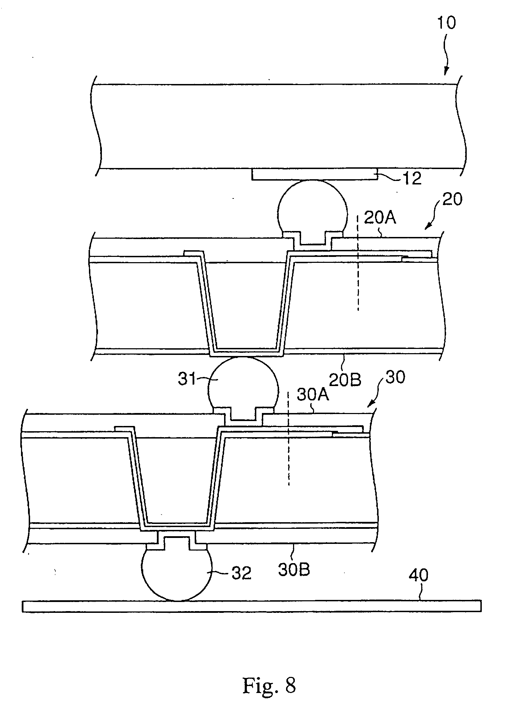

Fig. 8 is a sectional explanatory view showing a state where the semiconductor device according to the present invention is mounted on the circuit board 40. As seen from Fig. 8, the first wafer unit 10, second wafer unit 20 and third wafer unit 30 mentioned from above are stacked into the multilayer sandwich-like structure, and this structure is mounted on and bonded with the circuit board 40 (such as printed-wiring circuit board or interposer) through the bump 32 located on the rear surface 30B of the third wafer unit 30. In this way, the semiconductor device of the present invention forms the 3D (three-dimensional) device structure on the circuit board 40.

Although the semiconductor device of the present invention can be constructed of the two wafer units; the first wafer unit and the second wafer unit, it can also be constructed by stacking more wafer units; the third wafer unit and a fourth wafer unit as may be needed. Each of the series of manufactural processing steps, such as thinning the wafer unit, depositing and etching the insulating layer (insulating film), solder bumping, and stacking the wafer units, can be appropriately repeated as may be needed. Besides, the 3D semiconductor device comprising the semiconductor device according to the present invention is diced (split) intopellets, and the pellets are assembled into electron devices, which are offered to the market.

Incidentally, although not shown in Fig. 8, underfill (a sealing resin) or the like is packed into spaces defined between the adjacent ones of the wafer units (10, 20, 30) and between the wafer unit 30 and the circuit board 40, whereby the construct ion of the device can be more stabilized.

According to the present invention thus far described, excellent effects as stated below are demonstrated:
- Any of prior-art 3D semiconductor devices has been fabricated by a manufacturing method of chip-to-chip correspondence, not by a manufacturing method of wafer-to-wafer correspondence, so that it has not been suited to mass production. The semiconductor device of the present invention is manufactured by a bonding process at a wafer level, and has a mass-producibility which is much higher than that of the prior-art device based on a bonding process at a chip level.
- The formation of a bump, the bonding of a wafer, and the reduction of the thickness of the wafer are made at the wafer level, and they can be performed by employing conventional equipment immediately available in the market, without requiring any special manufacturing equipment.
- A manufactural process which is carried out on the rear surface side of a wafer unit is permitted to proceed without holding a manufacturing equipment and the front surface of the wafer unit in touch. If the front surface touches the manufacturing equipment, a large number of problems such as an inferior available percentage and damages to a device might occur. In contrast, the present invention is free from such apprehensions.
- Since a semiconductor device according to the present invention is constructed as a multilayer sandwich-like structure, it can enhance the performance and functions of an electron device by a very simple construction and manufacturing method. Further, it can greatly contribute to reducing a size, lightening a weight, thinning, curtailing a cost, bettering a design, and so forth.

## Claims

1. A semiconductor device comprising a plurality of wafer units which are stacked, wherein that first one of said wafer units which is employed as a wafer base, and the other wafer units are bonded in series through bumps which are formed on surfaces of said wafer units, thereby to form a multilayer-wafer-unit 3D structure.

2. A semiconductor device as defined in Claim 1, wherein each of, at least, said other wafer units includes an integrated circuit.

3. A semiconductor device as defined in either of Claims 1 and 2, wherein said plurality of wafer units are bonded by manufactural means at a wafer level of wafer-to-wafer correspondence.

4. A semiconductor device as defined in any of Claims 1 through 3, wherein each of said other wafer units is formed by thinning from its rear surface side.

5. A semiconductor device as defined in any of Claims 1 through 4, wherein an insulating film is deposited on each of said other wafer units, and it is etched as may be needed.

6. An electron device comprising a semiconductor device, and a circuit board to which said semiconductor device is bonded, wherein said semiconductor device is as defined in any of Claims 1 through 5.
